# EUROPÄISCHE PATENTSCHRIFT

(11) **EP 2 324 096 B1**
(45) Veröffentlichungstag und Bekanntmachung des Hinweises auf die Patenterteilung: **16.08.2017**
(21) Anmeldenummer: 09748712.8
(22) Anmeldetag: 02.11.2009
(51) Int. Cl.: C09K 11/59, H01L 33/50

(54) **CO-DOTIERTE 1-1-2 NITRIDE**
CODOPED 1-1-2 NITRIDES
NITRURES 1-1-2 CO-DOPÉS

(30) Priorität: 22.11.2008 DE 102008058621
(43) Veröffentlichungstag der Anmeldung: 25.05.2011
(73) Patentinhaber: Merck Patent GmbH, 64293 Darmstadt (DE)
(72) Erfinder: WINKLER, Holger, 64291 Darmstadt (DE); PETRY, Ralf, 64347 Griesheim (DE); VOSGROENE, Tim, 64372 Ober-Ramstadt (DE); JUESTEL, Thomas, 58455 Witten (DE); KASTELNIKOVAS, Arturas, 48565 Steinfurt (DE); UHLICH, Dominik, 48565 Steinfurt (DE)
(86) Internationale Anmeldenummer: PCT/EP2009/007826
(87) Internationale Veröffentlichungsnummer: WO 2010/057572

(56) Entgegenhaltungen:
- EP-A1- 2 009 078
- WO-A1-2005/049763
- WO-A1-2005/103199
- WO-A1-2009/003988
- DUAN C J ET AL: "Preparation, electronic structure, and photoluminescence properties of Eu<2+>- and Ce<3+>/Li<+>-activated alkaline earth silicon nitride MSiN2 (M = Sr, Ba)" CHEMISTRY OF MATERIALS AMERICAN CHEMICAL SOCIETY USA, Bd. 20, Nr. 4, 20. Oktober 2008 (2008-10-20), Seiten 1597-1605, XP002565799 ISSN: 0897-4756 DOI: 10.1021/cm701875e
- LEE S S ET AL: "P-2: PHOTOLUMINESCENCE AND ELECTROLUMINESCENCE IN MGXZN1-XSIN2 PHOSPHORS DOPED WITH EU AND TB" 1997 SID INTERNATIONAL SYMPOSIUM DIGEST OF TECHNICAL PAPERS. BOSTON, MAY 13 - 15, 1997; [SID INTERNATIONAL SYMPOSIUM DIGEST OF TECHNICAL PAPERS], SANTA ANA, SID, US, Bd. VOL. 28, 13. Mai 1997 (1997-05-13), Seiten 576-579, XP000722764
- LE TOQUIN, R., CHEETHAM, A.K.: "Red-emitting cerium-based phosphor materials for solid-statelighting applications" CHEMICAL PHYSICS LETTERS, Bd. 423, Nr. 4-6, 1. Juni 2006 (2006-06-01), Seiten 352-356, XP002565800 DOI: 10.1016/j.cplett.2006.03.056

## Beschreibung

Die Erfindung betrifft Verbindungen, die aus mit Ni²⁺, Co²⁺, Ru²⁺, Hf⁴⁺, Th⁴⁺ und/oder Zr⁴⁺ -co-dotierten 1-1-2-Erdalkalisiliconitriden mit Europium-Dotierung bestehen, deren Herstellung sowie deren Verwendung als Leuchtstoffe sowie LED-Konversionsleuchtstoffe für warm-weiße LEDs oder sogenannte Color-on-demand-Anwendungen.

Unter dem Color-on-demand Konzept versteht man die Realisierung von Licht eines bestimmten Farbpunktes mit einer pcLED (=phosphor converted LED) unter Einsatz eines oder mehrer Leuchtstoffe. Dieses Konzept wird z.B. verwendet, um bestimmte Corporate Designs z.B. für beleuchtete Firmenlogos, Marken etc. zu erzeugen.

Leuchtstoff-konvertierte LEDs stellen eine bedeutende Lichttechnologie dar, deren Innovationspotential zur zunehmenden Substitution von traditionellen künstlichen Lichtquellen (Glühfadenlampen, Entladungslampen etc.) führt.
Während die Halbleitertechnologie für LED nahezu ausgereizt ist, bieten die eingesetzten Leuchtstoffe Raum für Verbesserungen. Bei den LED-Herstellern wird die Notwendigkeit von roten Leuchtstoffen für (power) LEDs immer wieder betont. Erforderliche Eigenschaften roter Leuchtstoffe für den effizienten und effektiven Einsatz in der LED sind u. a.:
- Emissionsbanden in einem Wellenlängenbereich von 610 - 620 nm (Allgemeinbeleuchtung mit hohem CRI bzw. hoher CCT), bzw. 630 nm und 650 nm (Displayanwendungen).
- Hohe Fluoreszenzlöschtemperaturen (TQ₅₀ >> 150 °C)
- Hohe chemische Stabilität gegenüber Säuren und Feuchtigkeit
- Hohe Helligkeit, welche aus hoher Absorption im Spektralbereich der Emissionsbande der anregenden LED, hoher Emissionslichtextraktion aus dem Leuchtstoff an die Umgebung und hoher Konversionseffizienz (QE) resultiert.
Es gibt eine Reihe an Leuchtstoffmaterialsystemen, welche einige, aber nicht sämtliche der o.g. vom LED-Hersteller geforderten Bedingungen erfüllen. Jedoch erst die Erfüllung sämtlicher Bedingungen wird den Austausch von traditionellen elektrischen Lichtquellen durch LEDs stark beschleunigen und zu einer Verringerung der weltweit benötigten elektrischen Energie für Beleuchtung führen.
Kommerziell erhältliche Leuchtstoffmaterialien, welche im Roten fluoreszieren und mit blauen (oder UV-LEDs) prinzipiell kombiniert werden können, sind vor allem:

### a) Ortho-Silikate:

Die Materialien weisen eine hohe Helligkeit und Effizienz auf, die längste Emissionswellenlänge liegt jedoch bei ca. 610 nm und die Temperaturlöschung liegt bei TQ₅₀ = 150°. Da power LEDs solch hohe Betriebstemperaturen erreichen können, sind ortho-Silikate weitaus besser für LEDs geeignet, die mit Stromstärken kleiner als 350 mA betrieben werden (Quelle: M. Zachau, Präsentation Phosphor Global Summit 2006, 15.03.2007).

### b) Sulfide, Thiogallate und Sulfoselenide:

Diese Leuchtstoffe sind in der Lage in den o. a. Wellenlängenbereichen zu emittieren. Der größte Nachteil der schwefelhaltigen Materialien ist deren Instabilität gegen Luftsauerstoff und Feuchtigkeit. Beides gelangt in der LED über Diffusion durch das Silikon Bindermaterial sehr leicht an den Leuchtstoff und reagiert mit diesem, wobei er abgebaut wird. Zudem sind häufig nur geringe Dotierungsgrade möglich, wodurch es bei einer hohen Anregungsdichte zu Sättigungsphänomenen kommt.

### c) Nitride:

Kovalente Nitride können prinzipiell als Matrix für Leuchtstoffe eingesetzt werden, weil sie über eine große Bandlücke verfügen, in welcher der Grundzustand und typischerweise einige bis viele angeregte Zustände der Aktivatorionen lokalisiert sind. Durch die hohe Kovalenz verursacht, weisen Nitride einen großen nephelxauletischen Effekt auf, wodurch die Energie der niedrigsten Kristallfeldkomponente der angeregten 4f5d-Konfiguration von Seltenerd-Aktivatoren, z. B. Eu²⁺, Ce³⁺ verringert wird. Dies führt zu einer langwelligen Anregung und Emission von Nitridleuchtstoffen (siehe Krevel et al., J. Alloys Compd. 1998,268,272)
Insbesondere Siliconitride zeigen eine enge Verwandschaft zu Oxosiliziumverbindungen auf, da beide Systeme aus SiX₄ Tetraedern aufgebaut sind (X = O, N). Aufgrund des höheren Kondensationsgrades weisen Silikonitride allerdings eine höhere chemische Stabilität als Oxosiliziumverbindungen auf (siehe Xie et al, Sci.Tech. Adv. Mater. 2007,8, 588)
Insbesondere eignen sich Siliconitride zur Dotierung mit Aktivatorionen, wie Eu²⁺ und Ce³⁺, in denen mindestens ein Elektron im angeregten Zustand nicht von der Wirkung des Kristallfeldes (5s und 5d) abgeschirmt werden. Solche Aktivatoren weisen spektroskopische Eigenschaften auf, die sehr stark von der Umgebung (Symmetrie, Kovalenz, Koordination, Feldstärke, Bindungslängen, Gitterplatzgröße) abhängen. Die hohe Formalladung von Stickstoff (N³-) führt im Gegensatz zur niedrigeren Formalladung von Sauerstoff (O²⁻) dazu, dass o. a. Aktivatoren in Siliconitriden eine größere Kristallfeldaufspaltung der 5d Orbitale erfahren und der energetische Schwerpunkt der 5d Orbitale zu geringeren Energie verschoben wird als es in analogen Si-O-Materialien der Fall ist. Dadurch zeigen die Anregungs- und Emissionsbanden des Aktivators eine spektrale Rotverschiebung. Des Weiteren führt das stabilere und starrere Gitter der Siliconitride im Gegensatz zu dem der Oxosiliziumverbindungen dazu, dass der Stokes-Shift verringert wird, wodurch die thermische Löschung erst bei höheren Temperaturen stattfindet und die Konversionseffizienz erhöht wird.

Als erstes Leuchtstoffsystem der Siliconitride wurde das CaSiN₂.Eu²⁺ veröffentlicht (siehe Lim et a. SPIE Vol. 3241, 1997, Photoluminescence of CaSiN₂:Eu). Dieser Leuchtstoff eignet sich als Konverter in blau und UVemittierenden LEDs, weil er bei Anregung in diesen Wellenlängenbereichen Lumineszenz bei ca. 630 nm luminesziert.

WO 2005/049763 A1 beschreibt ein Verfahren zur Herstellung einer Nitridsilikat-basierten Verbindung, bei dem ein erster Reaktand, eine Siliziumverbindung und Kohlenstoff in einer Nitriergas-Atmosphäre umgesetzt werden, wobei der erste Reaktand entweder (i) ein Material ist, das eine durch Erwärmen in ein Erdalkalimetalloxid MO umwandelbare Erdalkalimetallverbindung enthält, wobei M mindestens ein Element, ausgewählt aus Mg, Ca, Sr und Ba, ist und O für Sauerstoff steht; oder (ii) ein Material ist, das mindestens ein Erdalkalimetall oder ein Nitrid eines Erdalkalimetalls enthält.

WO 2005/103199 A1 betrifft eine lichtemittierende Vorrichtung, die unter Verwendung einer Leuchtstoffzusammensetzung hergestellt wird. Die Leuchtstoffzusammensetzung enthält ein Leuchtstoff-Wirtsmaterial, die als Hauptbestandteil eine Zusammensetzung enthält, die durch eine Zusammensetzung der Formel aM₃N₂·bAlN·cSi₃N₄ dargestellt ist, wobei "M" mindestens ein Element, ausgewählt aus der Gruppe bestehend aus Mg, Ca, Sr, Ca und Zn, ist und "a", "b" und "c" Zahlenwerte sind, die die Bedingungen 0,2 ≤ a/(a+b) ≤ 0,95; 0,05 ≤ b/(b+c) ≤ 0,8 und 0,4 ≤ c/(c+a) ≤ 0.95 erfüllen.

Aufgabe der vorliegenden Erfindung ist es daher die o.g. 1-1-2-Erdalkali-Siliconitride so zu modifizieren, dass diese Verbindungen eine noch höhere Lichteffizienz erreichen.

Überraschenderweise wurde gefunden, dass die Anforderung nach einer wirtschaftlich bedeutenden weiteren Steigerung der Konversionseffizienz des Leuchtstoffes CaSiN₂:Eu²⁺ erfüllt werden kann, falls eine Co-Dotierung mit zwei- oder vierwertigen Kationen durchgeführt wird. Bei den analogen Leuchtstoffsystemen BaSiN₂:Eu und SrSiN₂:Eu wurde überraschenderweise ebenfalls eine deutliche Verstärkung der Lumineszenz entdeckt, indem eine Co-Dotierung durchgeführt wird.

Gegenstand der vorliegenden Erfindung sind somit 1-1-2-Erdalkali-siliconitride mit Europium-Dotierung der Zusammensetzung M₁Si₁N₂:Eu²⁺, wobei M ein Erdalkalimetall oder eine Mischung aus mehreren Erdalkalimetallen darstellt, die zusätzlich Co-Dotanten aus der Reihe Nickel, Cobalt, Ruthenium, Hafnium, Thorium und/oder Zirkonium enthalten.

Unter "1-1-2-Erdalkali-siliconitriden" (auch "1-1-2-Nitride oder "1-1-2-Erdalkali-nitridosilikate genannt) versteht man solche Zusammensetzungen M₁Si₁N₂:Eu²⁺, wobei M ein Erdalkalimetall oder eine Mischung aus mehreren Erdalkalimetallen darstellt.

Bevorzugt sind Verbindungen der Formel I

(Ca,Sr,Ba)_{1-x-y}Me_{y}SiN₂:Euₓ (I)

wobei Me=Ni²⁺, Co²⁺ und/oder Ru²⁺
x= 0,005 bis 0,20 und
y < 1
gilt.

Weiterhin erfindungsgemäß bevorzugt sind Verbindungen der Formel II

(Ca,Sr,Ba)₁₋ₓSi_{1-z}Ma_{z}N₂ :Euₓ (II)

wobei
Ma = Hf ⁴⁺, Th⁴⁺ und/oder Zr⁴⁺
x = 0,005 bis 0,20 und
z < 1
gilt.

Bevorzugt ist es, wenn der y-Wert (der für die Atomkonzentration der Co-Dotanten Me bzw. Ma steht) gleich 0.0005 bis 0.2, noch bevorzugter gleich 0,001 bis 0,02 beträgt.

Bevorzugt ist es weiterhin, wenn x = 0.05 bis 0.15 ist.

Die größere Helligkeit der erfindungsgemäßen Verbindungen bzw. Leuchtstoffe gemäß den Formeln I bis II gegenüber denjenigen identischer Zusammensetzung, aber ohne die Co-Dotanden Ni, Co und/oder Ru lässt sich mit den dem Fachmann bekannten Theorien dadurch erklären, dass diese Ionen einen Einfluss auf die Lebensdauer der angeregten Zustände der Aktivatorionen aufweisen: Angeregte Elektronen solcher Leuchtstoffe kehren nach kürzerer Zeit unter Aussendung des Fluoreszenzlichtes wieder in den Grundzustand zurück. D.h. diese Elektronen können in demselben Zeitintervall mehr Anregungs- und Relaxatationsprozesse durchführen. (s. S. Shionoya, W. M. Yen, Phosphor Handbook, CRC Press, New York, 1999, ISBN 0-8493-7560-6),
Die Partikelgröße der erfindungsgemäßen Verbindungen beträgt zwischen 50 nm und 30 µm, vorzugsweise zwischen 1 µm und 20 µm, noch bevorzugter zwischen 2 und 15 µm.

Des Weiteren können in dem Kristallgitter der erfindungemäßen Verbindungen zusätzlich noch einwertige Ionen wie Alkali- oder Erdalkalimetalle z.B. Li, Na, K, Ca, Sr, Ba und Halogenide wie F oder Cl eingebaut sein. Diese einwertigen Ionen werden vorzugsweise als Flussmittel bei der Leuchtstoffherstellung eingesetzt und dienen zur Erhöhung der Kristallqualität, Grobeinstellung der Partikelgröße und der Partikelmorphologie und besitzen dadurch ein hohes Potential zur Effizienzsteigerung der Leuchtstoffe. Diese Vorgehensweise ist dem Fachmann bekannt (siehe z.B. H.S. Kang et al. Mater. Science and Engineering B 121 (2005) 81-85).

In einer bevorzugten Ausführungsform der vorliegenden Erfindung ist die Verbindung erhältlich durch Mischen von Siliciumnitrid-, Europium- und Calcium- und/oder Strontium- und /oder Barium-haltigen Edukten mit mindestens einem Nickel-, Cobalt-, Ruthenium-, Hafnium-, Thorium- und/oder Zirkonium-haltigen Co-Dotierstoff nach Festkörperdiffusionsmethoden und anschließender thermischer Nachbehandlung, welcher gegebenenfalls ein Flussmittel aus der Reihe der Alkali- oder Erdalkalihalogenide oder auch eine Boratverbindung enthalten kann.

Ein weiterer Gegenstand der vorliegenden Erfindung ist ein Verfahren zur Herstellung der erfindungsgemäßen Verbindung mit folgenden Verfahrensschritten:
a) Herstellen einer Eu-dotierten 1-1-2-Erdalkali-siliconitrid-Verbindung, die mit Nickel-, Cobalt-Ruthenium-, Hafnium- Thorium- und/oder Zirkonium-haltigen Materialien co-dotiert wird, durch Mischen von mindestens 4 Edukten ausgewählt aus Siliciumnitrid-, Europium-, Calcium-, Strontium-, Barium-, Nickel-, Cobalt-, Ruthenium, Hafnium, Thorium- und/oder Zirkonium-haltigen Materialien,
b) Thermische Nachbehandlung der Ni-, Co-, Ru-, Hf-, Th- und/oder Zr-co-dotierten Verbindung.

Die Edukte zur Herstellung der Verbindung bestehen, wie oben erwähnt, aus Siliciumnitrid (Si₃N₄), Calciumhydrid und Europiumfluorid sowie mindestens einem Ni-, Co-, Ru-, Hf-, Th- und/oder Zrhaltigen Co-Dotierstoff. Als Edukte kommen neben den bevorzugten Nitriden, Hydriden und Fluoriden auch weitere anorganische und/oder organische Stoffe wie Cyanamide, Dicyanamide, Cyanide, Oxalate, Malonate, Fumarate, Carbonate, Citrate, Ascorbate und Acetylacetonate in Frage.

Die oben genannte thermische Nachbehandlung (siehe Verfahrensschritt b) verläuft mehrere Stunden unter reduzierenden Bedingungen, z. B mit Formiergas (z.B.90/10), reinem Wasserstoff und/oder in Ammoniak-Atmosphäre mit oder ohne den oben aufgeführten Atmosphären. Die Temperaturen beim Glühprozess betragen zwischen 1000°C und 1800°C, vorzugsweise von 1200°C bis 1650°C.

Mit Hilfe der o.g. Verfahren können beliebige äußere Formen der erfindungsgemäßen Verbindungen bzw. Leuchtstoffe, hergestellt werden, wie sphärische Partikel, Plättchen und strukturierte Materialien und Keramiken. Diese Formen werden erfindungsgemäß unter dem Begriff "Formkörper" zusammengefasst. Vorzugsweise handelt es sich bei dem Formkörper um einen "Leuchtstoffkörper".

Ein weiterer Gegenstand der vorliegenden Erfindung ist somit ein Leuchtstoffkörper enthaltend die erfindungsgemäßen Verbindungen, wobei er eine raue Oberfläche besitzt, die Nanopartikel aus SiO₂, TiO₂, Al₂O₃, ZnO, ZrO₂ und/oder Y₂O₃ oder Mischoxide daraus und/oder Partikel mit der erfindungsgemäßen Verbindung mit oder ohne Dotierstoffen aus der Reihe Europium, Nickel, Cobalt, Ruthenium, Hafnium, Thorium und/oder Zirkonium.

In einer weiteren bevorzugten Ausführungsform besitzt der Formkörper auf der, einem LED Chip entgegengesetzten Seite eine strukturierte (z.B. pyramidale) Oberfläche (siehe WO2008/058619, Merck, die voll umfänglich in den Kontext der vorliegenden Anmeldung durch Bezugnahme eingefügt wird). Somit kann möglichst viel Licht aus dem Leuchtstoff ausgekoppelt werden.

Die strukturierte Oberfläche auf dem Formkörper wird durch nachträgliches Beschichten mit einem geeigneten Material, welches bereits strukturiert ist, oder in einem nachfolgenden Schritt durch (photo-) lithografische Verfahren, Ätzverfahren oder durch Schreibverfahren mit Energie- oder Materiestrahlen oder Einwirkung von mechanischen Kräften hergestellt.

In einer weiteren bevorzugten Ausführungsform besitzen die erfindungsgemäßen Formkörper auf der, einem LED Chip entgegengesetzten Seite eine raue Oberfläche, die Nanopartikel aus SiO₂, TiO₂, Al₂O₃, ZnO₂, ZrO₂ und/oder Y₂O₃ oder Kombinationen aus diesen Materialien und/oder aus Partikeln mit der Leuchtstoffzusammensetzung gemäß Formel I und II mit oder ohne Dotierstoffen aus der Reihe Ni, Co und/oder Ru trägt. Dabei hat eine raue Oberfläche eine Rauhigkeit von bis zu einigen 100 nm. Die beschichtete Oberfläche hat den Vorteil, dass Totalreflexion verringert oder verhindert werden kann und das Licht besser aus dem erfindungsgemäßen Leuchtstoff ausgekoppelt werden kann (siehe WO2008/058619 (Merck), die voll umfänglich in den Kontext der vorliegenden Anmeldung durch Bezugnahme eingefügt wird.)

Weiterhin bevorzugt ist es, wenn die erfindungsgemäßen Formkörper auf der dem Chip abgewandten Oberfläche eine Brechzahl angepasste Schicht besitzen, welche die Auskopplung der Primärstrahlung und oder der vom Leuchtstoffkörper emittierten Strahlung erleichtert.

In einer weiteren bevorzugten Ausführungsform besitzen die Formkörper eine geschlossene Oberflächenbeschichtung, die aus SiO₂, TiO₂, Al₂O₃, ZnO, ZrO₂ und/oder Y₂O₃ oder Mischoxide und/oder aus den Verbindungen gemäß Formel I oder II ohne den Aktivator Europium besteht. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächenbeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schließlich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn der Formkörper eine poröse Oberflächenbeschichtung besitzt, die aus SiO₂, TiO₂, Al₂O₃, ZnO, ZrO₂ und/oder Y₂O₃ oder Mischoxide daraus und/oder aus den Verbindungen gemäß Formeln I oder II mit oder ohne Dotierstoffen aus der Reihe Eu, Ni, Co, Ru, Hf, Th und/oder Zr besteht. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

In einer weiteren bevorzugten Ausführungsform besitzt der Formkörper eine Oberfläche, die funktionelle Gruppen trägt, welche eine chemische oder physikalische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht. Von einer physikalischen Anbindung an die Umgebung spricht man in diesem Zusammenhang, wenn zwischen den Systemen elektrostatische Wechselwirkungen über Ladungsfluktuationen oder Partialladungen wirken.

Da die auf dem LED Chip aufgebrachte erfindungsgemäße Leuchtstoffschicht vorzugsweise aus einem Gemisch von Silikon und homogenen Leuchtstoffpartikeln besteht, und das Silikon eine Oberflächenspannung aufweist, ist diese Leuchtstoffschicht auf mikroskopischer Ebene nicht einheitlich bzw. ist die Dicke der Schicht nicht durchweg konstant.

Die Herstellung von plättchenförmigen Leuchtstoffen als weitere bevorzugte Ausführungsform geschieht nach herkömmlichen Verfahren aus den entsprechenden Metall- und/oder Seltenerd-Salzen. Das Herstellverfahren ist in EP 763573 und WO2008/058620 ausführlich beschrieben, welche voll umfänglich in den Kontext der vorliegenden Anmeldung durch Bezugnahme eingefügt werden. Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂ -, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem Material aufgebaut sein. Falls das Plättchen selbst lediglich als Träger für die Leuchtstoffbeschichtung dient, muss diese aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z.B. Silikon- oder Epoxidharz), dispergiert und diese Dispersion wird auf dem LED Chip aufgebracht.

Die plättchenförmigen Leuchtstoffe können in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm. Er besitzt in der Regel ein Aspektverhältnis (Verhältnis des Durchmessers zur Teilchendicke) von 1 : 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.
Die dem LED Chip zugewandte Oberfläche des plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den erfindungsgemäßen Leuchtstoffkörper eingekoppelt werden kann.
Hierfür eignen sich beispielsweise brechzahl-angepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen.

Die Herstellung der erfindungsgemäßen Leuchtstoffkörper in Form von keramischen Körpern erfolgt analog nach dem in der WO 2008/ 017353 (Merck) beschrieben Verfahren, die voll umfänglich in den Kontext der vorliegenden Anmeldung durch Bezugnahme eingefügt wird. Dabei wird der Leuchtstoff durch Mischen der entsprechenden Edukte und Dotierstoffe hergestellt, anschließend isostatisch verpresst und in Form eines homogenen dünnen und nicht porösen Plättchens direkt auf die Oberfläche des Chips aufgebracht oder in Abstand zum Chip (remote phosphor-Konzept). Die jeweilige Anordnung hängt u.a. von der Architektur des LED devices ab, wobei der Fachmann in der Lage ist, die vorteilhafte Anordnung auszuwählen. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneider der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.
Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.

Der keramische Leuchtstoffkörper kann, falls erforderlich, mit einer Wasserglaslösung auf dem Untergrund eines LED Chip fixiert werden.

In einer weiteren Ausführungsform besitzt der keramische Leuchtstoffkörper auf der, einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Ein weiterer Gegenstand ist ein Verfahren zur Herstellung eines Leuchtstoffkörpers, mit folgenden Verfahrensschritten:
a) Herstellen einer Europium-dotierten 1-1-2-Erdalkali-siliconitrid-Verbindung, die mit Nickel-, Cobalt-, Ruthenium-, Hafnium-, Thorium- und/oder Zirkonium-haltigen Materialien codotiert wird, durch Mischen von mindestens 4 Edukten ausgewählt aus Siliciumnitrid-, Europium-, Calcium-, Strontium-, Barium-, Nickel-, Cobalt-, Ruthenium-, Hafnium-, Thorium- und/oder Zirkonium-haltigen Materialien,
b) Thermische Nachbehandlung der mit Nickel-, Cobalt-, Ruthenium-, Hafnium-, Thorium- und/oder Zirkoniumcodotierten Verbindung und Entstehung eines Formkörpers mit rauer Oberfläche,
c) Beschichtung der rauen Oberfläche mit Nanopartikeln aus SiO₂ TiO₂, Al₂O₃, ZnO, ZrO₂ und/oder Y₂O₃ oder Mischoxide daraus oder mit Nanopartikeln aus den erfindungsgemäßen Verbindungen.

Die Anregbarkeit der erfindungsgemäßen Leuchtstoffe erstrecken sich zudem über einen weiten Bereich, der von etwa 410 nm bis 530 nm, bevorzugt 430 nm bis zu etwa 500 nm reicht. Damit sind diese Leuchtstoffe nicht nur zur Anregung durch UV oder blau emittierende Primärlichtquellen wie LEDs oder konventionelle Entladungslampen (z.B. auf Hg-Basis) geeignet, sondern auch für Lichtquelle wie solche, weiche die blaue in³⁺ - Linie bei 451 nm ausnutzen.

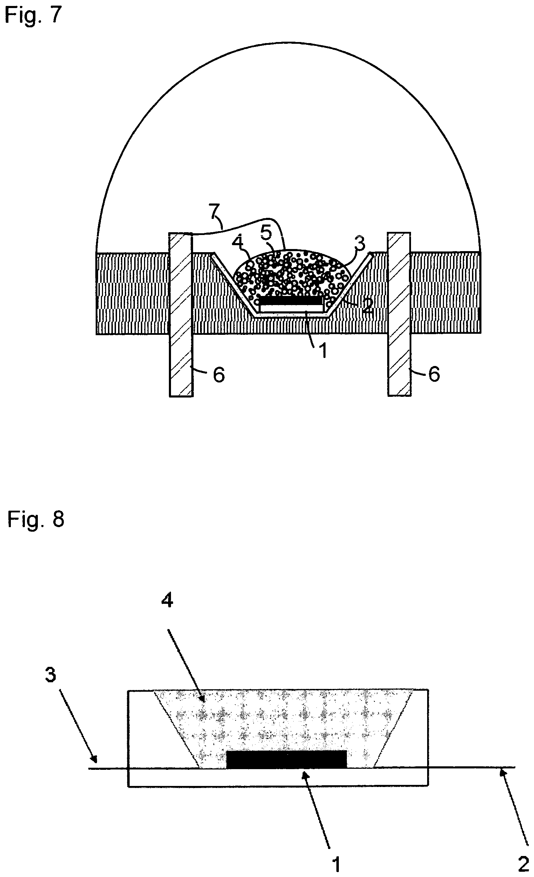

Ein weiterer Gegenstand der vorliegenden Erfindung ist eine Beleuchtungseinheit mit mindestens einer Primärlichtquelle, dessen Emissionsmaximum bzw. -maxima im Bereich 410 nm bis 530 nm, bevorzugt 430 nm bis zu etwa 500 nm reicht. Insbesondere bevorzugt ist ein Bereich zwischen 440 und 480 nm, wobei die primäre Strahlung teilweise oder vollständig durch die erfindungsgemäßen Verbindungen bzw. Leuchtstoffe in längerwellige Strahlung konvertiert wird. Vorzugsweise ist diese Beleuchtungseinheit weiß emittierend oder emittiert Licht mit einem bestimmten Farbpunkt (Color-on-demand-Prinzip). Bevorzugte Ausführungsformen der erfindungsgemäßen Beleuchtungseinheiten sind in den Figuren 7 bis 18 dargestellt.

In einer bevorzugten Ausführungsform der erfindungsgemäßen Beleuchtungseinheit handelt es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist.
Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der erfindungsgemäßen Beleuchtungseinheit handelt es sich bei der Lichtquelle um eine lumineszente auf ZnO, TCO (Transparent conducting oxide), ZnSe oder SiC basierende Anordnung oder auch um eine auf einer organischen lichtemittierende Schicht basierende Anordnung (OLED).

In einer weiteren bevorzugten Ausführungsform der erfindungsgemäßen Beleuchtungseinheit handelt es sich bei der Lichtquelle um eine Quelle, die Elektrolumineszenz und/oder Photoiumineszenz zeigt. Weiterhin kann es sich bei der Lichtquelle auch um eine Plasma- oder Entladungsquelle handeln.

Die erfindungsgemäßen Leuchtstoffe können entweder in einem Harz dispergiert (z.B. Epoxy- oder Siliconharz), oder bei geeigneten Größenverhältnissen direkt auf der Primärlichtquelle angeordnet werden oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol. 44, No. 21 (2005). L649-L651.

In einer weiteren Ausführungsform ist es bevorzugt, wenn die optische Ankopplung der Beleuchtungseinheit zwischen dem Leuchtstoff und der Primärlichtquelle durch eine lichtleitende Anordnung realisiert wird. Dadurch ist es möglich, dass an einem zentralen Ort die Primärlichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an die Primärlichtquelle angekoppelt ist, realisieren. Auf diese Weise ist es möglich, eine starke Primärlichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Ein weiterer Gegenstand der vorliegenden Erfindung ist die Verwendung der erfindungsgemäßen Verbindungen als Konversionsleuchtstoff zur teilweisen oder vollständigen Konversion der blauen oder im nahen UV-liegenden Emission einer Lumineszenzdiode.

Weiterhin bevorzugt ist die Verwendung der erfindungsgemäßen Verbindungen zur Konversion der blauen oder im nahen UV-liegenden Emission in sichtbare weiße Strahlung. Weiterhin ist die Verwendung der erfindungsgemäßen Verbindungen zur Konversion der Primärstrahlung in einen bestimmten Farbpunkt nach dem "Color on demand"- Konzept bevorzugt.

Die erfindungsgemäßen Verbindungen der Formel I und II können einzeln, oder als Mischung mit den dem Fachmann geläufigen folgenden Leuchtstoffen eingesetzt werden:
Ba₂SiO₄:Eu²⁺, BaSi₂O₅:Pb²⁺, BaₓSri₁₋ₓF₂:Eu²⁺, BaSrMgSi₂O₇:Eu²⁺, BaTiP₂O₇, (Ba,Ti)₂P₂O₇:Ti, Ba₃WO₆:U, BaY₂F₈ Er³⁺,Yb⁺, Be₂SiO₄:Mn²⁺, Bi₄Ge₃O₁₂, CaAl₂O₄:Ce³⁺, CaLa₄O₇:Ce³⁺, CaAl₂O₄:Eu²⁺, CaAl₂O₄:Mn²⁺, CaAl₄O₇:Pb²⁺,Mn²⁺, CaAl₂O₄:Tb³⁺, Ca₃Al₂Si₃O₁₂:Ce³⁺, Ca₃Al₂Si₃Oi₂:Ce³⁺, Ca₃Al₂Si₃O,₂:Eu²⁺, Ca₂B₅O₉Br:Eu²⁺, Ca₂B₅O₉Cl:Eu²⁺, Ca₂B₅O₉Cl:Pb²⁺, CaB₂O₄:Mn²⁺, Ca₂B₂O₅:Mn²⁺, CaB₂O₄:Pb²⁺, CaB₂P₂O₉:Eu²⁺, Ca₅B₂SiO₁₀:Eu³⁺, Ca₀.₅Ba₀.₅Al₁₂O₁₉:Ce³⁺,Mn²⁺, Ca₂Ba₃(PO₄)₃Cl:Eu²⁺, CaBr₂:Eu²⁺ in SiO₂, CaCl₂:Eu²⁺ in SiO₂, CaCl₂:Eu²⁺,Mn²⁺ in SiO₂, CaF₂:Ce³⁺, CaF₂:Ce³⁺,Mn²⁺, CaF₂:Ce³⁺,Tb³⁺, CaF₂:Eu²⁺, CaF₂:Mn²⁺, CaF₂:U, CaGa₂O₄:Mn²⁺, CaGa₄O₇:Mn²⁺, CaGa₂S₄:Ce³⁺, CaGa₂S₄:Eu²⁺, CaGa₂S₄:Mn²⁺, CaGa₂S₄:Pb²⁺, CaGeO₃:Mn²⁺, Cal₂:Eu²⁺ in SiO₂, Cal₂:Eu²⁺,Mn²⁺ in SiO₂, CaLaBO₄:Eu³⁺, CaLaB₃O₇:Ce³⁺,Mn²⁺, Ca₂La₂BO₆.₅:Pb²⁺, Ca₂MgSi₂O₇, Ca₂MgSi₂O₇:Ce³⁺, CaMgSi₂O₆:Eu²⁺, Ca₃MgSi₂O₈:Eu²⁺, Ca₂MgSi₂O₇:Eu²⁺, CaMgSi₂O₆:Eu²⁺,Mn²⁺, Ca₂MgSi₂O₇:Eu²⁺,Mn²⁺, CaMoO₄, CaMoO₄:Eu³⁺, CaO:Bi³⁺, CaO:Cd²⁺, CaO:Cu⁺, CaO:Eu³⁺, CaO:Eu³⁺, Na⁺, CaO:Mn²⁺, CaO:Pb²⁺, CaO:Sb³⁺, CaO:Sm³⁺, CaO:Tb³⁺, CaO:Tl, CaO:Zn²⁺, Ca₂P₂O₇:Ce³⁺, -α-Ca₃(PO₄)₂:Ce³⁺, β-Ca₃(PO₄)₂:Ce³⁺, Ca₅(PO₄)₃Cl:Eu²⁺, Ca₅(PO₄)₃Cl:Mn²⁺, Ca₅(PO₄)₃Cl:Sb³⁺, Ca₅(PO₄)₃Cl:Sn²⁺, β-Ca₃(PO₄)₂:Eu²⁺, Mn²⁺, Ca₅(PO₄)₃F:Mn²⁺, Caₛ(PO₄)₃F:Sb³⁺, Caₛ(PO₄)₃F:Sn²⁺, α-Ca₃(PO₄)₂:Eu²⁺, β-Ca₃(PO₄)₂:Eu²⁺, Ca₂P₂O₇:Eu²⁺, Ca₂P₂O₇:Eu²⁺,Mn²⁺, CaP₂O₆:Mn²⁺, α-Ca₃(PO₄)₂:Pb²⁺, α-Ca₃(PO₄)₂:Sn²⁺, β-Ca₃(PO₄)₂:Sn²⁺, β-Ca₂P₂O₇:Sn,Mn, α-Ca₃(PO₄)₂:Tr, CaS:Bi³⁺, CaS:Bi³⁺,Na, CaS:Ce³⁺, CaS:Eu²⁺, CaS:Cu⁺,Na⁺, + CaS:La³⁺, CaS:Mn²⁺, CaSO₄:Bi, CaSO₄:Ce³⁺, CaSO₄:Ce³⁺,Mn²⁺, CaSO₄:Eu²⁺, CaSO₄:Eu²⁺,Mn²⁺, CaSO₄:Pb²⁺, CaS:Pb²⁺, CaS:Pb²⁺,Cl, CaS:Pb²⁺,Mn²⁺, CaS:Pr³⁺,Pb²⁺,Cl, CaS:Sb³⁺, CaS:Sb³⁺,Na, CaS:Sm³⁺, CaS:Sn²⁺, CaS:Sn²⁺,F, CaS:Tb³⁺, CaS:Tb³⁺,Cl, CaS:Y³⁺, CaS:Yb²⁺, CaS:Yb²⁺,Cl, CaSiO₃:Ce³⁺, Ca₃SiO₄Cl₂:Eu²⁺, Ca₃SiO₄Cl₂:Pb²⁺, CaSiO₃:Eu²⁺, CaSiO₃:Mn²⁺,Pb, CaSiO₃:Pb²⁺, CaSiO₃:Pb²⁺,Mn²⁺, CaSiO₃:Ti⁴⁺, CaSr₂(PO₄)₂:Bi³⁺, β-(Ca,Sr)₃(PO₄)₂:Sn²⁺Mn²⁺, CaTi_{0.9}Al_{0.1}O₃:Bi³⁺, CaTiO₃:Eu³⁺, CaTiO₃:Pr³⁺, Ca₅(VO₄)₃Cl, CaWO₄₎ CaWO₄:Pb²⁺, CaWO4:W, Ca₃WO₆:U, CaYAlO₄:Eu³⁺, CaYBO₄:Bi³⁺, CaYBO₄:Eu³⁺, CaYB_{0.8}O₃.₇:Eu³⁺, CaY₂ZrO₆:Eu³⁺, (Ca,Zn,Mg)₃(PO₄)₂:Sn, CeF₃, (Ce,Mg)BaAl₁₁O₁₈:Ce, (Ce,Mg)SrAl₁₁O₁₈:Ce, CeMgAl₁₁O₁₉:Ce:Tb, Cd₂B₆O₁₁:Mn²⁺, CdS:Ag⁺,Cr, CdS:In, CdS:In, CdS:In,Te, CdS:Te, CdWO₄, CsF, Csl, Csl:Na⁺, Csl:Tl, (ErCl₃)_{0.25}(BaC)₂)_{0.75}. GaN:Zn, Gd₃Ga₅O₁₂:Cr³⁺, Gd₃Ga₅O₁₂:Cr,Ce, GdNbO₄:Bi³⁺, Gd₂O₂S:Eu³⁺, Gd₂O₂Pr³⁺, Gd₂O₂S:Pr,Ce,F, Gd₂O₂S:Tb³⁺, Gd₂SiO₅:Ce³⁺, KAl₁₁O₁₇:Tl⁺, KGa₁₁O₁₇:Mn²⁺, K₂La₂Ti₃O₁₀;Eu, KMgF₃:Eu²⁺, KMgF₃:Mn²⁺, K₂SiF₆:Mn⁴⁺, LaAl₃B₄O₁₂:Eu³⁺, LaAlB₂O₆:Eu³⁺, LaAlO₃:Eu³⁺, LaAlO₃:Sm³⁺, LaAsO₄:Eu³⁺, LaBr₃:Ce³⁺, LaBO₃:Eu³⁺, (La,Ce,Tb)PO₄:Ce:Tb, LaCl₃:Ce³⁺, La₂O₃:Bi³⁺, LaOBr:Tb³⁺, LaOBr:Tm³⁺, LaOCl:Bi³⁺, LaOCl:Eu³⁺, LaOF:Eu³⁺, La₂O₃:Eu³⁺, La₂O₃:Pr³⁺, La₂O₂S:Tb³⁺, LaPO₄:Ce³⁺, LaPO₄:Eu³⁺, LaSiO₃Cl:Ce³⁺, LaSiO₃Cl:Ce³⁺,Tb³⁺, LaVO₄:Eu³⁺, La₂W₃O₁₂:Eu³⁺, LiAlF₄:Mn²⁺, LiAl₅O₈:Fe³⁺, LiAlO₂:Fe³⁺, LiAlO₂:Mn²⁺, LiAl₅O₈:Mn²⁺, Li₂CaP₂O₇:Ce³⁺,Mn²⁺, LiCeBa₄Si₄O₁₄:Mn²⁺, LiCeSrBa₃Si₄O₁₄:Mn²⁺, LiInO₂:Eu³⁺, LiInO₂:Sm³⁺, LiLaO₂:Eu³⁺, LuAlO₃:Ce³⁺, (Lu,Gd)₂SiO₅:Ce³⁺, Lu₂SiO₅:Ce³⁺, Lu₂Si₂O₇:Ce³⁺, LuTaO₄:Nb⁵⁺, Lu₁₋ₓYₓAlO₃:Ce³⁺, MgAl₂O₄:Mn²⁺, MgSrAl₁₀O₁₇:Ce, MgB₂O₄:Mn²⁺, MgBa₂(PO₄)₂:Sn²⁺, MgBa₂(PO₄)₂:U, MgBaP₂O₇:Eu²⁺, MgBaP₂O₇:Eu²⁺,Mn²⁺, MgBa₃Si₂O₈:Eu²⁺, MgBa(SO₄)₂:Eu²⁺, Mg₃Ca₃(PO₄)₄:Eu²⁺, MgCaP₂O₇:Mn²⁺, Mg₂Ca(SO₄)₃:Eu²⁺, Mg₂Ca(SO₄)₃:Eu²⁺,Mn², MgCeAlₙO₁₉:Tb³⁺, Mg₄(F)GeO₆:Mn²⁺, Mg₄(F)(Ge,Sn)O₆:Mn²⁺, MgF₂:Mn²⁺, MgGa₂O₄:Mn²⁺, Mg₈Ge₂O₁₁F₂:Mn⁴⁺, MgS:Eu²⁺, MgSiO₃:Mn²⁺, Mg₂SiO₄:Mn²⁺, Mg₃SiO₃F₄:Ti⁴⁺, MgSO₄:Eu²⁺, MgSO₄:Pb²⁺, MgSrBa₂Si₂O₇:Eu²⁺, MgSrP₂O₇:Eu²⁺, MgSr₅(PO₄)₄:Sn²⁺, MgSr₃Si₂O₈:Eu²⁺,Mn²⁺, Mg₂Sr(SO₄)₃:Eu²⁺, Mg₂TiO₄:Mn⁴⁺, MgWO₄, MgYBO₄:Eu³⁺, Na₃Ce(PO₄)₂:Tb³⁺, Nal:Tl, Na_{1.23}K_{O.42}Eu_{0.12}TiSi₄O₁₁:Eu³⁺, Na_{1.23}K_{0.42}Eu_{0.12}TiSi₅O₁₃·xH₂O:Eu³⁺, Na_{1.29}K_{0.46}Er_{0.08}TiSi₄O₁₁:Eu³⁺, Na₂Mg₃Al₂Si₂O₁₀:Tb, Na(Mg₂₋ₓMnₓ)LiSi₄O₁₀F₂:Mn, NaYF₄:Er³⁺, Yb³⁺, NaYO₂:Eu³⁺, P46(70%) + P47 (30%), SrAl₁₂O₁₉:Ce³⁺, Mn²⁺, SrAl₂O₄:Eu²⁺, SrAl₄O₇:Eu³⁺, SrAl₁₂O₁₉:Eu²⁺, SrAl₂S₄:Eu²⁺, Sr₂B₅O₉Cl:Eu²⁺_{,} SrB₄O₇:Eu²⁺(F,Cl,Br), SrB₄O₇:Pb²⁺, SrB₄O₇:Pb²⁺, Mn²⁺, SrB₈O₁₃:Sm²⁺, SrₓBa_{y}Cl_{z}Al₂O_{4-z/2}: Mn²⁺, Ce³⁺, SrBaSiO₄:Eu²⁺, Sr(Cl,Br,I)₂:Eu²⁺ in SiO₂, SrCl₂:Eu²⁺ in SiO₂, Sr₅Cl(PO₄)₃:Eu, Sr_{w}FₓB₄O_{6.5}:Eu²⁺, Sr_{w}FₓB_{y}O_{z}:Eu²⁺,Sm²⁺, SrF₂:Eu²⁺, SrGa₁₂O₁₉:Mn²⁺, SrGa₂S₄:Ce³⁺, SrGa₂S₄:Eu²⁺, SrGa₂S₄:Pb²⁺, SrIn₂O₄:Pr³⁺, Al³⁺, (Sr,Mg)₃(PO₄)₂:Sn, SrMgSi₂O₆:Eu²⁺, Sr₂MgSi₂O₇:Eu²⁺, Sr₃MgSi₂O₈:Eu²⁺, SrMoO₄:U, SrO·3B₂O₃:Eu²⁺,Cl, β-SrO.3B₂O₃:Pb²⁺, β-SrO·3B₂O₃:Pb²⁺,Mn²⁺, α-SrO·3B₂O₃:Sm²⁺, Sr₆P₅BO₂₀:Eu, Sr₅(PO₄)₃Cl:Eu²⁺, Sr₅(PO₄)₃Cl:Eu²⁺,Pr³⁺, Sr₅(PO₄)₃Cl:Mn²⁺, Sr₅(PO₄)₃Cl:Sb³⁺, Sr₂P₂O₇:Eu²⁺, β-Sr₃(PO₄)₂:Eu²⁺, Sr₅(PO₄)₃F:Mn²⁺, Sr₅(PO₄)₃F:Sb³⁺, Sr₅(PO₄)₃F:Sb3⁺,Mn²⁺, Sr₅(PO₄)₃F:Sn²⁺, Sr₂P₂O₇:Sn²⁺, β-Sr₃(PO₄)₂:Sn²⁺, β-Sr₃(PO₄)₂:Sn²⁺,Mn²⁺(Al), SrS:Ce³⁺, SrS:Eu²⁺, SrS:Mn²⁺, SrS:Cu⁺,Na, SrSO₄:Bi, SrSO₄:Ce³⁺, SrSO₄:Eu²⁺, SrSO₄:Eu²⁺,Mn²⁺, Sr₅Si₄O₁₀Cl₆:Eu²⁺, Sr₂SiO₄:Eu²⁺, SrTiO₃:Pr³⁺, SrTiO₃:Pr³⁺,Al³⁺, Sr₃WO₆:U, SrY₂O₃:Eu³⁺, ThO₂:Eu³⁺, ThO₂:Pr³⁺, ThO₂:Tb³⁺, YAl₃B₄O₁₂:Bi³⁺, YAl₃B₄O₁₂:Ce³⁺, YAl₃B₄O₁₂:Ce³⁺,Mn, YAl₃B₄O₁₂:Ce³⁺,Tb³⁺, YAl₃B₄O₁₂:Eu³⁺, YAl₃B₄O₁₂:Eu³⁺,Cr³⁺, YAl₃B₄O₁₂:Th⁴⁺,Ce³⁺,Mn²⁺, YAlO₃:Ce³⁺, Y₃Al₅O₁₂:Ce³⁺, Y₃Al₅O₁₂:Cr³⁺, YAlO₃:Eu³⁺, Y₃Al₅O₁₂:Eu^{3r}, Y₄Al₂O₉:Eu³⁺, Y₃Al₅O₁₂:Mn⁴⁺, YAlO₃:Sm³⁺, YAlO₃:Tb³⁺, Y₃Al₅O₁₂:Tb³⁺, YAsO₄:Eu³⁺, YBO₃:Ce³⁺, YBO₃:Eu³⁺, YF₃:Er³⁺,Yb³⁺, YF₃:Mn²⁺, YF₃:Mn²⁺,Th⁴⁺, YF₃:Tm³⁺,Yb³⁺, (Y,Gd)BO₃:Eu, (Y,Gd)BO₃:Tb, (Y,Gd)₂O₃:Eu³⁺, Y_{1.34}Gd_{0.60}O₃(Eu,Pr), Y₂O₃:Bi³⁺, YOBr:Eu³⁺, Y₂O₃:Ce, Y₂O₃:Er³⁺, Y₂O₃:Eu³⁺(YOE), Y₂O₃:Ce³⁺,Tb³⁺, YOCl:Ce³⁺, YOCl:Eu³⁺, YOF:Eu³⁺, YOF:Tb³⁺, Y₂O₃:Ho³⁺, Y₂O₂S:Eu³⁺, Y₂O₂S:Pr³⁺, Y₂O₂S:Tb³⁺, Y₂O₃:Tb³⁺, YPO₄:Ce³⁺, YPO₄:Ce³⁺,Tb³⁺, YPO₄:Eu³⁺, YPO₄:Mn²⁺,Th⁴⁺, YPO₄:V⁵⁺, Y(P,V)O₄:Eu, Y₂SiO₅:Ce³⁺, YTaO₄, YTaO₄:Nb⁵⁺, YVO₄:Dy³⁺, YVO₄:Eu³⁺, ZnAl₂O₄:Mn²⁺, ZnB₂O₄:Mn²⁺, ZnBa₂S₃:Mn²⁺, (Zn,Be)₂SiO₄:Mn²⁺, Zn_{0.4}Cd₀.₆S:Ag, Zn_{0.6}Cd_{0.4}S:Ag, (Zn,Cd)S:Ag,Cl, (Zn,Cd)S:Cu, ZnF₂:Mn²⁺, ZnGa₂O₄, ZnGa₂O₄:Mn²⁺, ZnGa₂S₄:Mn²⁺, Zn₂GeO₄:Mn²⁺, (Zn,Mg)F₂:Mn²⁺, ZnMg₂(PO₄)₂:Mn²⁺, (Zn,Mg)₃(PO₄)₂:Mn²⁺, ZnO:Al³⁺,Ga³⁺, ZnO:Bi³⁺, ZnO:Ga³⁺, ZnO:Ga, ZnO-CdO:Ga, ZnO:S, ZnO:Se, ZnO:Zn, ZnS:Ag⁺,Cl⁻, ZnS:Ag,Cu,Cl, ZnS:Ag,Ni, ZnS:Au,In, ZnS-CdS (25-75), ZnS-CdS (50-50), ZnS-CdS (75-25), ZnS-CdS:Ag,Br,Ni, ZnS-CdS:Ag⁺,Cl, ZnS-CdS:Cu,Br, ZnS-CdS:Cu,I, ZnS:Cl⁻, ZnS:Eu²⁺, ZnS:Cu. ZnS:Cu⁺,Al3⁺, ZnS:Cu⁺,Cl⁻, ZnS:Cu,Sn, ZnS:Eu²⁺, ZnS:Mn²⁺, ZnS:Mn,Cu, ZnS:Mn²⁺,Te²⁺, ZnS:P, ZnS:P³⁻,Cr, ZnS:Pb²⁺, ZnS:Pb2⁺,Cl⁻, ZnS:Pb,Cu, Zn₃(PO₄)₂:Mn²⁺, Zn₂SiO₄:Mn²⁺, Zn₂SiO₄:Mn²⁺,As⁵⁺, Zn₂SiO₄:Mn,Sb₂O₂, Zn₂SiO₄:Mn²⁺,P, Zn₂SiO₄:Ti⁴⁺, ZnS:Sn²⁺, ZnS:Sn,Ag, ZnS:Sn²⁺Li⁺, ZnS:Te,Mn, ZnS-ZnTe:Mn²⁺, ZnSe:Cu⁺,Cl, ZnWO₄

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### Beispiel 1: Herstellung von CaSiN₂:Eu (2-at-%)

- Die Präparation des Referenz-Leuchtstoffes erfolgt in einer Glovebox unter trockener N₂-Atmosphäre (rel. Luftfeuchtigkeit < 1 %)
- 0,98 mol CaH₂ (41,2364 g), 0,33 mol Si₃N₄ (46,2934 g), und 0,02 mol EuF₃ (4,179 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt.

### Beispiel 1a (Referenz): Herstellung von mit 0,005 at-% Mg codotiertem CaSiN₂:Eu (2-at-%)

- Die Präparation erfolgt in einer Glovebox unter trockener N₂-Atmosphäre (rel. Luftfeuchtigkeit < 1 %)
- 0,979951 mol CaH₂ (41,2341 g), 0,33 mol Si₃N₄ (46,2934 g), 0,02 mol EuF₃ (4,179 g) und 0,000049 mol MgF₂ (0,0031 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt.

### Beispiel 1b (Referenz): Herstellung von mit 0,005 at-% Be codotiertem CaSiN₂:Eu (2-at-%)

- Die Präparation erfolgt in einer Glovebox unter trockener N₂-Atmosphäre (rel. Luftfeuchtigkeit < 1%)
- 0,979951 mol CaH₂ (41,2341 g), 0,33 mol Si₃N₄ (46,2934 g), 0,02 mol EuF₃ (4,179 g) und 0,000049 mol BeF₂ (0,0023 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt

### Beispiel 1c (Referenz): Herstellung von mit 0,005 at-% Mn codotiertem CaSiN₂:Eu (2-at-%)

- Die Präparation erfolgt in einer Glovebox unter trockener N₂-Atmosphäre (rel. Luftfeuchtigkeit < 1%)
- 0,979951 mol CaH₂ (41,2341 g), 0,33 mol Si₃N₄ (46,2934 g), 0,02 mol EuF₃ (4,179 g) und 0,000049 mol MnCl₂ (0,0062 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt

### Beispiel 1d: Herstellung von mit 0,005 at-% Ni codotiertem CaSiN₂:Eu (2-at-%)

- Die Präparation erfolgt in einer Glovebox unter trockener N₂-Atmosphäre (rel. Luftfeuchtigkeit < 1%)
- 0,979951 mol CaH₂ (41,2341 g), 0,33 mol Si₃N₄ (46,2934 g), 0,02 mol EuF₃ (4,179 g) und 0,000049 mol NiF₂ (0,0047 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt

### Beispiel 1e: Herstellung von mit 0,005 at-% Co codotiertem CaSiN₂:Eu (2-at-%)

- Die Präparation erfolgt in einer Glovebox unter trockener N₂-Atmosphäre (rel. Luftfeuchtigkeit < 1%)
- 0,979951 mol CaH₂ (41,2341 g), 0,33 mol Si₃N₄ (46,2934 g), 0,02 mol EuF₃ (4,179 g) und 0,000049 mol CoF₂ (0,0047 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt

### Beispiel 1f: Herstellung von mit 0,005 at-% Ru codotiertem CaSiN₂:Eu (2-at-%)

- Die Präparation erfolgt in einer Glovebox unter trockener N₂-Atmosphäre (rel. Luftfeuchtigkeit <1%)
- 0,979951 mol CaH₂ (41,2341 g), 0,33 mol Si₃N₄ (46,2934 g), 0,02 mol EuF₃ (4,179 g) und 0,000049 mol RuF₂ (0,0059 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt

### Beispiel 1g: Herstellung von mit 0,005 at-% Hf codotiertem CaSiN₂:Eu (2-at-%)

- Die Präparation erfolgt in einer Glovebox unter trockener N₂-Atmosphäre (rel. Luftfeuchtigkeit < 1%)
- 0,98 mol CaH₂ (41,2364 g), 0,32995 mol Si₃N₄ (46,2863 g), 0,02 mol EuF₃ (4,179 g) und 0,00005 mol HfF₄ (0,0127 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt

### Beispiel 1h: Herstellung von mit 0,005 at-% Th codotiertem CaSiN₂:Eu (2-at-%)

- Die Präparation erfolgt in einer Glovebox unter trockener N₂-Atmosphäre (rel. Luftfeuchtigkeit < 1%)
- 0,98 mol CaH₂ (41,2364 g), 0,32995 mol Si₃N₄ (46,2863 g), 0,02 mol EuF₃ (4,179 g) und 0,00005 mol ThF₄ (0,0154 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt

### Beispiel 1 i: Herstellung von mit 0,005 at-% Zr codotiertem CaSiN₂:Eu (2-at-%)

- Die Präparation erfolgt in einer Glovebox unter trockener N₂-Atmosphäre (rel. Luftfeuchtigkeit < 1%)
- 0,98 mol CaH₂ (41,2364 g), 0,32995 mol Si₃N₄ (46,2863 g), 0,02 mol EuF₃ (4,179 g) und 0,00005 mol ZrF₄ (0,0084 g) werden in der Glovebox eingewogen und in einem Achatmörser homogenisiert
- Die Mischung wird in einen Mo-Tiegel gefüllt und in ein geeignetes Transportgefäß überführt
- Der Tiegel wird unter einem kontinuierlichen Argon-Strom in einen Rohrofen überführt und 8 Stunden unter Formiergas 90/10 und NH₃ bei 1500°C geheizt

### Beschreibung der Abbildungen

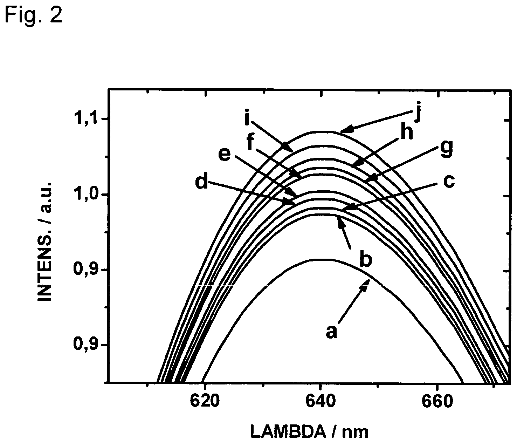

Im folgenden soll die Erfindung anhand mehrerer Ausführungsbeispiele näher erläutert werden. Es zeigen:

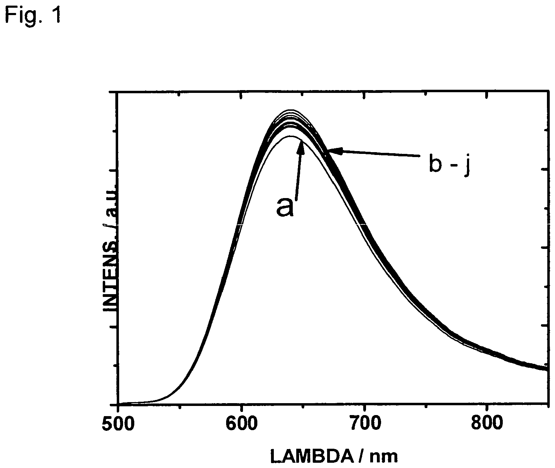

Fig. 1: zeigt das Emissionsspektrum von Ca₀,₉₈SiN₂:Eu_{0,02} und co-dotiertem Leuchtstoff bei 450 nm Anregung
   a) reines Ca₀,₉₈SiN₂:Eu₀,₀₂
   b) - j) Ca_{0,98}SiN₂:Eu₀,₀₂ mit Co-dotanden (jeweils 0,005 at-%):
      b = Mg, c = Be, d = Mn, e = Ni, f = Co, g = Zr, h = Ru, i = Hf, j = Th
Fig.2 : zeigt eine Ausschnittsvergrößerung von Fig.1 zur besseren Unterscheidung der Emissionsspektren a bis j.

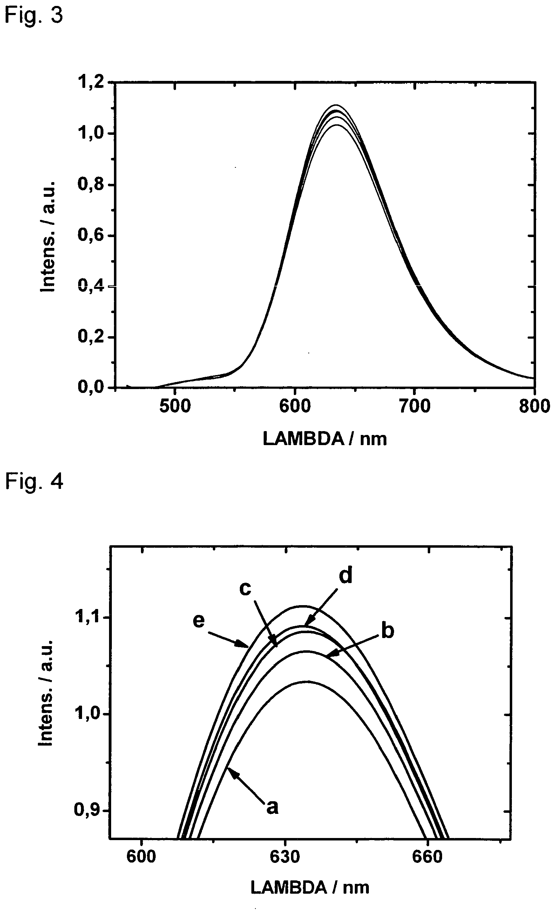

Fig.3: zeigt das Emissionsspektrum von Sr_{0,98}SiN₂:Eu_{0,02} und co-dotiertem Leuchtstoff bei einer Anregungswellenlänge 450 nm.
Fig. 4 : zeigt eine Ausschnittsvergrößerung von Fig. 3 zur besseren Unterscheidung der Emissionsspektren. Es bedeuten a) reines Sr_{0,98}SiN₂:Eu_{0,02}, b) Sr_{0,98}SiN₂:Eu_{0,02} mit 0,005 at-% Mg bzw. Be co-dotiert; c) Sr_{0,98}SiN₂:Eu_{0,02} mit 0,005 at-% Ni bzw. Co co-dotiert; d) Sr_{0,98}SiN₂:Eu_{0,02} mit 0,005 at-% Ru bzw. Mn bzw. Zr co-dotiert; e) Sr_{0,98}SiN₂:Eu_{0,02} mit 0,005 at-% Hf bzw. Th co-dotiert.

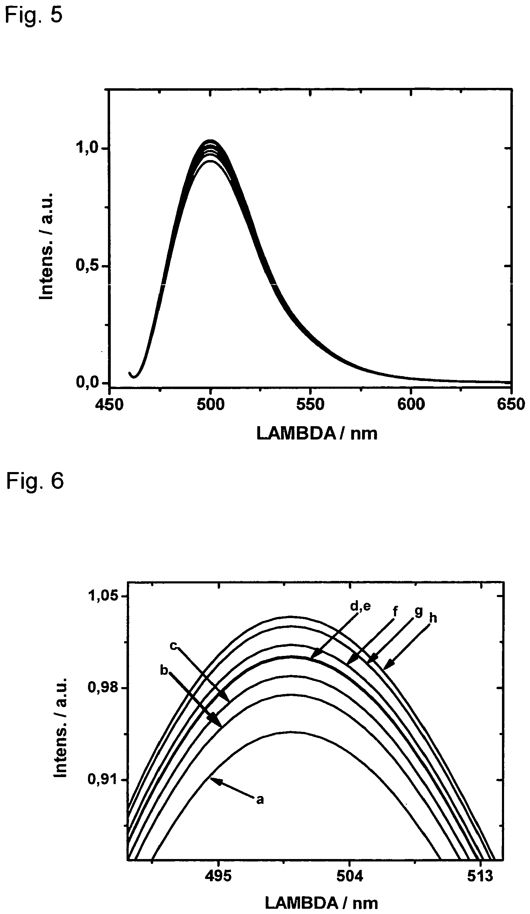

Fig. 5: zeigt das Emissionsspektrum von Ba_{0,98}SiN₂:Eu_{0,02} und co-dotiertem Leuchtstoff bei einer Anregungswellenlänge 450 nm.
Fig. 6: zeigt eine Ausschnittsvergrößerung von Fig. 5 zur besseren Unterscheidung der Emissionsspektren. Es bedeuten: a) reines Ba_{0,98}SiN₂:Eu_{0,02} ; b) Ba_{0,98}SiN₂:Eu_{0,02} mit 0,005 at-% Mg co-dotiert; c) Baₒ,₉₈SiN₂:E_{UO},₀₂ mit 0,005 at-% Be co-dotiert; d) Ba_{0,98}SiN₂:Eu_{0,02} mit 0,005 at-% Mn co-dotiert; e) Ba_{0,98}SiN₂:Eu_{0,02} mit 0,005 at-% Ni bzw. Co co-dotiert; f) Ba_{0,98}SiN₂:Eu_{0,02} mit 0,005 at-% Zr co-dotiert; g) Ba₀,₉₈SiN₂:Eu_{0,02} mit 0,005 at-% Ru bzw. Hf co-dotiert; h) Ba_{0,98}SiN₂:Eu_{0,02} mit 0,005 at-% Zr bzw. Th co-dotiert.
Fig. 7: zeigt die schematische Abbildung einer Leuchtdiode mit einer Leuchtstoff-haltigen Beschichtung. Das Bauteil umfasst eine Chip-artige LED 1 als Strahlungsquelle. Die LED ist ein einem becherförmigen Reflektor angebracht, der von einem Justagerahmen 2 gehalten wird. Der Chip 1 ist über ein Flachkabel 7 mit einem ersten Kontakt 6 und direkt mit einem zweiten elektrischen Kontakt 6' verbunden. Auf die innere Wölbung des Reflektorsbechers wurde eine Beschichtung aufgebracht, die einen erfindungsgemäßen Konversionsleuchtstoff enthält. Die Leuchtstoffe werden entweder getrennt voneinander oder als Mischung eingesetzt. (Liste der Teilenummern: 1 Leuchtdiode, 2 Reflektor, 3 Harz, 4 Konversionsleuchtstoff, 5 Diffusor, 6 Elektroden, 7 Flachkabel) Fig.8: zeigt ein Golden Dragon^{®} Package, das als Lichtquelle (LED) für weißes Licht dient (1=Halbleiterchip; 2,3 = elektr. Anschlüsse; 4 = Konversionsleuchtstoff in Kavität mit Reflektor). Der Konversionsleuchtstoff befindet sich in einem Bindemittel dispergiert, wobei die Mischung die Kavität ausfüllt.

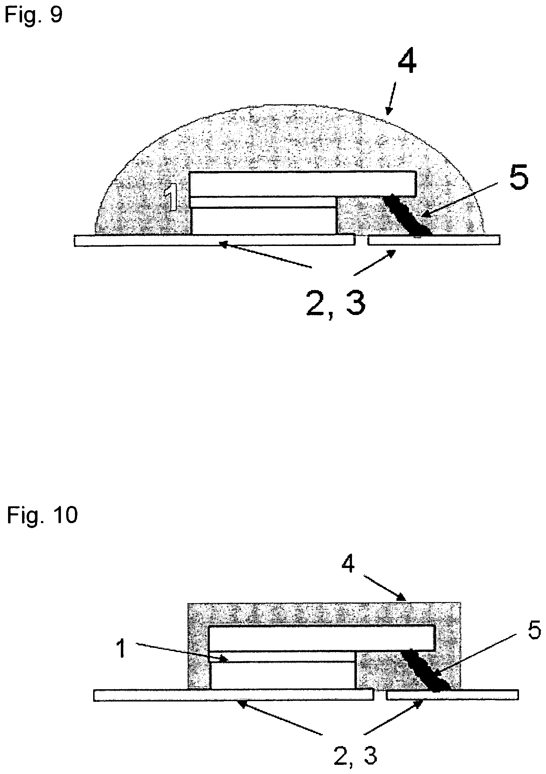

Fig. 9: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff in einem Bindemittel als Top Globe aufgebracht ist. Diese Form der Leuchtstoff-/Bindemittelschicht kann als sekundäres optisches Element wirken und z. B. die Lichtausbreitung beeinflussen.
Fig. 10: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff als dünne Schicht in einem Bindemittel dispergiert aufgebracht ist. Auf diese Schicht lässt sich leicht ein weiteres, als sekundäres optisches Element wirkendes Bauteil, wie z.B eine Linse aufbringen.

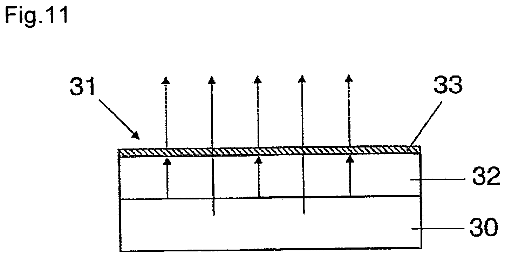

Fig. 11: zeigt ein Beispiel für eine weitere Anwendung, wie sie im Prinzip bereits aus US-B 6,700,322 bekannt ist. Dabei wird der erfindungsgemäße Leuchtstoff zusammen mit einer OLED angewendet. Die Lichtquelle ist eine organisch lichtemittierende Diode 31, bestehend aus der eigentlichen organischen Folie 30 und einem transparenten Substrat 32. Die Folie 30 emittiert insbesondere blaues primäres Licht, erzeugt beispielsweise mittels PVK:PBD:Kumarin (**PVK**, Abk. für Poly(n-vinylcarbazol); **PBD**, Abk. für 2-(4-biphenyl)-5-(4-tert.-butylphenyl)-1,3,4-oxadiazol)). Die Emission wird von einer Deckschicht, gebildet aus einer Schicht 33 des erfindungsgemäßen Leuchtstoffs, teilweise in gelbes, sekundär emittiertes Licht umgewandelt, so dass insgesamt durch Farbmischung des primär und sekundär emittierten Lichts eine weiße Emission realisiert wird. Die OLED besteht im wesentlichen aus mindestens einer Schicht eines lichtemittierenden Polymers oder von sog. small molecules zwischen zwei Elektroden, die aus an sich bekannten Materialien bestehen, wie beispielsweise ITO (Abk. für "indium tin oxide") als Anode und ein hochreaktives Metall, wie z.B. Ba oder Ca, als Kathode. Oft werden auch mehrere Schichten zwischen den Elektroden verwendet, die entweder als Lochtransportschicht dienen oder im Bereich der "small molecules" auch als Elektronentransportschichten dienen. Als emittierende Polymere kommen beispielsweise Polyfluorene oder Polyspiro-Materialien zum Einsatz.

## Patentansprüche

1. 1-1-2-Erdalkali-silikonitrid mit Europium-Dotierung der Zusammensetzung M₁Si₁N₂:Eu²⁺, wobei M ein Erdalkalimetall oder eine Mischung aus Erdalkalimetallen darstellt, welches zusätzlich Co-Dotanten aus der Reihe Ni, Co, Ru, Hf, Th und/ oder Zr enthält.

2. Verbindung nach Anspruch 1, **gekennzeichnet durch** die Formel I
(Ca,Sr,Ba)₁₋ₓ₋yMe_{y}SiN₂:Euₓ (I)
wobei
Me = Ni²⁺, Co²⁺ und/oder Ru²⁺
x= 0,005 bis 0,20 und
y < 1
ist.

3. Verbindung nach Anspruch 1, **gekennzeichnet durch** die Formel II
(Ca,Sr,Ba)₁₋ₓSi_{1-z}Ma_{z}N₂:Euₓ (II)
wobei
Ma = Hf⁴⁺, Th⁴⁺ und/oder Zr⁴⁺
x = 0,005 bis 0,20 und
z < 1
ist.

4. Verbindung nach einem oder mehreren der Ansprüche 1 bis 3, **dadurch gekennzeichnet, dass** y = 0,0005 bis 0,2 und/oder z = 0,0005 bis 0,2 ist.

5. Verbindung nach einem oder mehreren der Ansprüche 1 bis 4, **dadurch gekennzeichnet, dass** x = 0,05 bis 0,15 und/oder y = 0,001 bis 0,02 und/oder z = 0,001 bis 0,02 ist.

6. Verbindung nach einem oder mehreren der Ansprüche 1 bis 5, erhältlich durch Mischen von Siliciumnitrid- , Europium- und Calcium- und/oder Strontium- und /oder Barium-haltigen Edukten mit mindestens einem Nickel-, Cobalt-, Ruthenium-, Hafnium-, Thorium- und/oder Zirkonium-haltigen Co-Dotierstoff nach Festkörperdiffusionsmethoden und anschließender thermischer Nachbehandlung.

7. Verfahren zur Herstellung einer Verbindung nach einem oder mehreren der Ansprüche 1 bis 5 mit folgenden Verfahrensschritten:
a) Herstellen einer Europium-dotierten 1-1-2-Erdalkali-siliconitrid-Verbindung, die mit Nickel-, Cobalt-, Ruthenium-, Hafnium-, Thorium- und/oder Zirkonium-haltigen Materialien co-dotiert wird, durch Mischen von mindestens 4 Edukten ausgewählt aus Siliciumnitrid-, Europium-, Calcium-, Strontium-, Barium-, Nickel-, Cobalt-, Ruthenium-, Hafnium-, Thorium- und/oder Zirkonium-haltigen Materialien,
b) Thermische Nachbehandlung der mit Nickel-, Cobalt-, Ruthenium-, Hafnium-, Thorium- und/oder Zirkonium- co-dotierten Verbindung.

8. Leuchtstoffkörper, enthaltend eine Verbindung nach einem oder mehreren der Ansprüche 1 bis 5, **dadurch gekennzeichnet, dass** er eine raue Oberfläche besitzt, die Nanopartikel aus SiO₂, TiO₂, Al₂O₃, ZnO, ZrO₂ und/oder Y₂O₃ oder Mischoxiden daraus und/ oder Partikel mit der Verbindung nach einem oder mehreren der Ansprüche 1 bis 5 mit oder ohne Dotierstoffen aus der Reihe Europium, Nickel, Cobalt, Ruthenium, Hafnium, Thorium und/oder Zirkonium trägt.

9. Leuchtstoffkörper enthaltend eine Verbindung nach einem oder mehreren der Ansprüche 1 bis 5, **dadurch gekennzeichnet, dass** er eine geschlossene Oberflächenbeschichtung besitzt, die aus SiO₂, TiO₂, Al₂O₃, ZnO, ZrO₂ und/oder Y₂O₃ oder Mischoxiden daraus und /oder aus der Verbindung nach einem oder mehreren der Ansprüche 1 bis 5 ohne den Aktivator Europium besteht.

10. Leuchtstoffkörper enthaltend eine Verbindung nach einem oder mehreren der Ansprüche 1 bis 5, **dadurch gekennzeichnet, dass** er eine poröse Oberflächenbeschichtung besitzt, die aus SiO₂, TiO₂, Al₂O₃, ZnO, ZrO₂ und/oder Y₂O₃ oder Mischoxiden daraus und/ oder aus der Verbindung nach einem oder mehreren der Ansprüche 1 bis 5 mit oder ohne Dotierstoffen aus der Reihe Europium, Nickel, Cobalt, Ruthenium, Hafnium, Thorium und/oder Zirkonium besteht.

11. Leuchtstoffkörper enthaltend eine Verbindung nach einem oder mehreren der Ansprüche 1 bis 5, **dadurch gekennzeichnet, dass** die Oberfläche funktionelle Gruppen trägt, welche eine chemische oder physikalische Anbindung an die Umgebung, vorzugsweise bestehend aus Epoxy- oder Silikonharz, ermöglicht.

12. Beleuchtungseinheit mit mindestens einer Primärlichtquelle, deren Emissionsmaximum im Bereich 410 nm bis 530 nm liegt, vorzugsweise zwischen 430 nm und 500 nm, wobei diese Strahlung teilweise oder vollständig in längerwellige Strahlung konvertiert wird durch eine Verbindung und/oder Leuchtstoffkörper nach einem oder mehreren der Ansprüche 1 bis 11.

13. Beleuchtungseinheit nach Anspruch 12, **dadurch gekennzeichnet, dass** es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 handelt.

14. Beleuchtungseinheit nach Anspruch 12, **dadurch gekennzeichnet, dass** es bei der Lichtquelle um eine lumineszente auf ZnO, TCO (Transparent conducting oxide), ZnSe oder SiC basierende Verbindung handelt.

15. Beleuchtungseinheit nach Anspruch 12, **dadurch gekennzeichnet, dass** es sich bei der Lichtquelle um eine auf einer organischen lichtemittierenden Schicht basierendes Material handelt.

16. Beleuchtungseinheit nach Anspruch 12, **dadurch gekennzeichnet, dass** es sich bei der Lichtquelle um eine Plasma- oder Entladungslampe handelt.

17. Beleuchtungseinheit nach einem oder mehreren der Ansprüche 12 bis 16, **dadurch gekennzeichnet, dass** der Leuchtstoff direkt auf der Primärlichtquelle und/oder von dieser entfernt angeordnet ist.

18. Beleuchtungseinheit nach einem oder mehreren der Ansprüche 12 bis 17, **dadurch gekennzeichnet, dass** die optische Ankopplung zwischen dem Leuchtstoff und der Primärlichtquelle durch eine lichtleitende Anordnung realisiert ist.

19. Verwendung von mindestens einer Verbindung nach einem oder mehreren der Ansprüche 1 bis 6 als Konversionsleuchtstoff zur teilweisen oder vollständigen Konversion der blauen oder im nahen UV-liegenden Emission einer Lumineszenzdiode.

20. Verwendung von mindestens einer Verbindung nach einem oder mehreren der Ansprüche 1 bis 6 als Konversionsleuchtstoff zur Konversion der Primärstrahlung in einen bestimmten Farbpunkt nach dem Color-on-demand-Konzept.

## Claims

1. 1-1-2 alkaline-earth metal siliconitride with europium doping of the composition M₁Si₁N₂:Eu²⁺, where M represents an alkaline-earth metal or a mixture of alkaline-earth metals, which additionally comprises co-dopants from the series Ni, Co, Ru, Hf, Th and/or Zr.

2. Compound according to Claim 1, **characterised by** the formula I
(Ca,Sr,Ba)_{1-x-y}Me_{y}SiN₂:Euₓ (I)
where
Me = Ni²⁺, Co²⁺ and/or Ru²⁺
x = 0.005 to 0.20 and
y < 1.

3. Compound according to Claim 1, **characterised by** the formula II
(Ca,Sr,Ba)₁₋ₓSi_{1-z}Ma_{z}N₂:Euₓ (II)
where
Ma = Hf⁴⁺, Th⁴⁺ and/or Zr⁴⁺
x = 0.005 to 0.20 and
z < 1.

4. Compound according to one or more of Claims 1 to 3, **characterised in that** y = 0.0005 to 0.2 and/or z = 0.0005 to 0.2.

5. Compound according to one or more of Claims 1 to 4, **characterised in that** x = 0.05 to 0.15 and/or y = 0.001 to 0.02 and/or z = 0.001 to 0.02.

6. Compound according to one or more of Claims 1 to 5, obtainable by mixing silicon nitride-, europium- and calcium- and/or strontium- and/or barium-containing starting materials with at least one nickel-, cobalt-, ruthenium-, hafnium-, thorium- and/or zirconium-containing co-dopant by solid-state diffusion methods and subsequent thermal aftertreatment.

7. Process for the preparation of a compound according to one or more of Claims 1 to 5 having the following process steps:
a) preparation of a europium-doped 1-1-2 alkaline-earth metal siliconitride compound which is co-doped with nickel-, cobalt-, ruthenium-, hafnium-, thorium- and/or zirconium-containing materials, by mixing at least 4 starting materials selected from silicon nitride-, europium-, calcium-, strontium-, barium-, nickel-, cobalt-, ruthenium-, hafnium-, thorium- and/or zirconium-containing materials,
b) thermal aftertreatment of the compound co-doped with nickel, cobalt, ruthenium, hafnium, thorium and/or zirconium.

8. Phosphor body comprising a compound according to one or more of Claims 1 to 5, **characterised in that** it has a rough surface which carries nanoparticles comprising SiO₂, TiO₂, Al₂O₃, ZnO, ZrO₂ and/or Y₂O₃ or mixed oxides thereof and/or particles comprising the compound according to one or more of Claims 1 to 5 with or without dopants from the series europium, nickel, cobalt, ruthenium, hafnium, thorium and/or zirconium.

9. Phosphor body comprising a compound according to one or more of Claims 1 to 5, **characterised in that** it has a continuous surface coating which consists of SiO₂, TiO₂, Al₂O₃, ZnO, ZrO₂ and/or Y₂O₃ or mixed oxides thereof and/or of the compound according to one or more of Claims 1 to 5 without the activator europium.

10. Phosphor body comprising a compound according to one or more of Claims 1 to 5, **characterised in that** it has a porous surface coating which consists of SiO₂, TiO₂, Al₂O₃, ZnO, ZrO₂ and/or Y₂O₃ or mixed oxides thereof and/or of the compound according to one or more of Claims 1 to 5 with or without dopants from the series europium, nickel, cobalt, ruthenium, hafnium, thorium and/or zirconium.

11. Phosphor body comprising a compound according to one or more of Claims 1 to 5, **characterised in that** the surface carries functional groups which facilitate chemical or physical bonding to the environment, preferably consisting of epoxy or silicone resin.

12. Lighting unit having at least one primary light source whose emission maximum is in the range 410 nm to 530 nm, preferably between 430 nm and 500 nm, where this radiation is partly or completely converted into longer-wave radiation by a compound and/or phosphor body according to one or more of Claims 1 to 11.

13. Lighting unit according to Claim 12, **characterised in that** the light source is a luminescent indium aluminium gallium nitride, in particular of the formula InᵢGaⱼAlₖN, where 0 ≤ i, 0 ≤ j, 0 ≤ k, and i+j+k=1.

14. Lighting unit according to Claim 12, **characterised in that** the light source is a luminescent compound based on ZnO, TCO (transparent conducting oxide), ZnSe or SiC.

15. Lighting unit according to Claim 12, **characterised in that** the light source is a material based on an organic light-emitting layer.

16. Lighting unit according to Claim 12, **characterised in that** the light source is a plasma or discharge lamp.

17. Lighting unit according to one or more of Claims 12 to 16, **characterised in that** the phosphor is arranged directly on the primary light source and/or remote therefrom.

18. Lighting unit according to one or more of Claims 12 to 17, **characterised in that** the optical coupling between the phosphor and the primary light source is achieved by a light-conducting arrangement.

19. Use of at least one compound according to one or more of Claims 1 to 6 as conversion phosphor for the partial or complete conversion of the blue or near-UV emission from a luminescent diode.

20. Use of at least one compound according to one or more of Claims 1 to 6 as conversion phosphor for the conversion of the primary radiation into a certain colour point in accordance with the colour-on-demand concept.

## Revendications

1. Siliconitrure de métal alcalino-terreux 1-1-2 avec dopage à l'europium de la composition M₁Si₁N₂:Eu²⁺, où M représente un métal alcalino-terreux ou un mélange de métaux alcalino-terreux, lequel comprend de manière additionnelle des co-dopants issus de la série qui est constituée par le Ni, le Co, le Ru, le Hf, le Th et/ou le Zr.

2. Composé selon la revendication 1, **caractérisé par** la formule I :
(Ca,Sr,Ba)_{1-x-y}Me_{y}SiN₂:Euₓ (I)
dans laquelle :
Me = Ni²⁺, Co²⁺ et/ou Ru²⁺
x = 0,005 à 0,20 et
y < 1.

3. Composé selon la revendication 1, **caractérisé par** la formule II :
(Ca,Sr,Ba)₁₋ₓSi_{1-z}Ma_{z}N₂:Euₓ (II)
dans laquelle :
Ma = Hf⁴⁺, Th⁴⁺ et/ou Zr⁴⁺
x = 0,005 à 0,20 et
z < 1.

4. Composé selon une ou plusieurs des revendications 1 à 3, **caractérisé en ce que** y = 0,0005 à 0,2 et/ou z = 0,0005 à 0,2.

5. Composé selon une ou plusieurs des revendications 1 à 4, **caractérisé en ce que** x = 0,05 à 0,15 et/ou y = 0,001 à 0,02 et/ou z = 0,001 à 0,02.

6. Composé selon une ou plusieurs des revendications 1 à 5, lequel peut être obtenu en mélangeant des matériaux de départ qui contiennent du nitrure de silicium, de l'europium et du calcium et/ou du strontium et/ou du baryum avec au moins un co-dopant qui contient du nickel, du cobalt, du ruthénium, du hafnium, du thorium et/ou du zirconium au moyen de procédés de diffusion à l'état solide et d'un post-traitement thermique qui suit.

7. Procédé pour la préparation d'un composé selon une ou plusieurs des revendications 1 à 5 qui comporte les étapes de procédé qui suivent :
a) la préparation d'un composé de siliconitrure de métal alcalino-terreux 1-1-2 dopé à l'europium, lequel est co-dopé avec des matériaux qui contiennent du nickel, du cobalt, du ruthénium, du hafnium, du thorium et/ou du zirconium, en mélangeant au moins 4 matériaux de départ qui sont sélectionnés parmi des matériaux qui contiennent du nitrure de silicium, de l'europium, du calcium, du strontium, du baryum, du nickel, du cobalt, du ruthénium, du hafnium, du thorium et/ou du zirconium,
b) un post-traitement thermique du composé co-dopé avec du nickel, du cobalt, du ruthénium, du hafnium, du thorium et/ou du zirconium.

8. Corps en phosphore comprenant un composé selon une ou plusieurs des revendications 1 à 5, **caractérisé en ce qu'**il comporte une surface rugueuse qui est porteuse de nanoparticules qui comprennent du SiO₂, du TiO₂, de l'Al₂O₃, du ZnO, du ZrO₂ et/ou de l'Y₂O₃ ou des oxydes mélangés de ceux-ci et/ou de particules qui comprennent le composé selon une ou plusieurs des revendications 1 à 5 avec ou sans dopants issus de la série qui est constituée par l'europium, le nickel, le cobalt, le ruthénium, le hafnium, le thorium et/ou le zirconium.

9. Corps en phosphore comprenant un composé selon une ou plusieurs des revendications 1 à 5, **caractérisé en ce qu'**il comporte un revêtement de surface continu qui est constitué par du SiO₂, du TiO₂, de l'Al₂O₃, du ZnO, du ZrO₂ et/ou de l'Y₂O₃ ou des oxydes mélangés de ceux-ci et/ou par le composé selon une ou plusieurs des revendications 1 à 5 sans l'europium activateur.

10. Corps en phosphore comprenant un composé selon une ou plusieurs des revendications 1 à 5, **caractérisé en ce qu'**il comporte un revêtement de surface poreux qui est constitué par du SiO₂, du TiO₂, de l'Al₂O₃, du ZnO, du ZrO₂ et/ou de l'Y₂O₃ ou des oxydes mélangés de ceux-ci et/ou par le composé selon une ou plusieurs des revendications 1 à 5 avec ou sans des dopants qui sont issus de la série qui est constituée par l'europium, le nickel, le cobalt, le ruthénium, le hafnium, le thorium et/ou le zirconium.

11. Corps en phosphore comprenant un composé selon une ou plusieurs des revendications 1 à 5, **caractérisé en ce que** la surface est porteuse de groupes fonctionnels qui facilitent une liaison chimique ou physique sur l'environnement, lesquels groupes fonctionnels sont de préférence constitués par une résine époxy ou silicone.

12. Unité d'éclairage comportant au moins une source de lumière primaire dont un maximum d'émission est dans la plage de 410 nm à 530 nm, de façon préférable entre 430 nm et 500 nm, où ce rayonnement est partiellement ou complètement converti selon un rayonnement d'ondes plus longues au moyen d'un composé et/ou d'un corps en phosphore selon une ou plusieurs des revendications 1 à 11.

13. Unité d'éclairage selon la revendication 12, **caractérisée en ce que** la source de lumière est un nitrure d'indium, de gallium et d'aluminium luminescent, en particulier de la formule InᵢGaⱼAlₖN, dans laquelle 0 ≤ i, 0 ≤ j, 0 ≤ k, et i+j+k=1.

14. Unité d'éclairage selon la revendication 12, **caractérisée en ce que** la source de lumière est un composé luminescent à base de ZnO, de TCO (oxyde conducteur transparent), de ZnSe ou de SiC.

15. Unité d'éclairage selon la revendication 12, **caractérisée en ce que** la source de lumière est un matériau à base d'une couche émettrice de lumière organique.

16. Unité d'éclairage selon la revendication 12, **caractérisée en ce que** la source de lumière est une lampe à plasma ou à décharge.

17. Unité d'éclairage selon une ou plusieurs des revendications 12 à 16, **caractérisée en ce que** le phosphore est agencé directement sur la source de lumière primaire et/ou à distance de celle-ci.

18. Unité d'éclairage selon une ou plusieurs des revendications 12 à 17, **caractérisée en ce que** le couplage optique entre le phosphore et la source de lumière primaire est réalisé au moyen d'un agencement qui conduit la lumière.

19. Utilisation d'au moins un composé selon une ou plusieurs des revendications 1 à 6 en tant que phosphore de conversion pour la conversion partielle ou complète de l'émission de bleu ou des UV proches en provenance d'une diode luminescente.

20. Utilisation d'au moins un composé selon une ou plusieurs des revendications 1 à 6 en tant que phosphore de conversion pour la conversion du rayonnement primaire selon un certain point de couleur conformément au concept de couleur à la demande.
